# EUROPÄISCHE PATENTSCHRIFT

(11) **EP 2 811 650 B1**
(45) Veröffentlichungstag und Bekanntmachung des Hinweises auf die Patenterteilung: **29.07.2015**
(21) Anmeldenummer: 14165852.6
(22) Anmeldetag: 24.04.2014
(51) Int. Cl.: H03K 17/955

(54) **Annäherungserfassungsvorrichtung**
Proximity detection device
Dispositif de détection de proximité

(30) Priorität: 05.06.2013 DE 102013105792
(43) Veröffentlichungstag der Anmeldung: 10.12.2014
(73) Patentinhaber: Huf Hülsbeck & Fürst GmbH & Co. KG, 42551 Velbert (DE)
(72) Erfinder: Schindler, Mirko, 42549 Velbert (DE)
(74) Vertreter: Zenz Patentanwälte Partnerschaft mbB

(56) Entgegenhaltungen:
- EP-A1- 2 565 591
- US-A1- 2008 290 668
- US-A1- 2010 079 153
- US-A1- 2010 315 267
- US-A1- 2011 057 773
- US-B2- 7 064 960
- US-B2- 7 232 973

## Beschreibung

Die Erfindung betrifft eine Annäherungserfassungsvorrichtung mit einem Sensorsystem zum Erfassen der Annäherung eines Benutzers. Insbesondere betrifft die Erfindung Annäherungserfassungsvorrichtungen mit einem kapazitiven Annäherungssensor.

Kapazitive Sensoren bzw. entsprechende Systeme sind aus dem Stand der Technik bekannt und können berührungslos die Annäherung eines Benutzers erfassen. Dazu wird die Veränderung der Kapazität einer Elektrodenanordnung gemessen, wobei die Kapazität von dem Abstand eines Körperteils des Benutzers zu der Elektrodenanordnung abhängig ist. Eine entsprechende Elektrodenanordnung ist beispielsweise in der DE 10 2005 061 755 A1 beschrieben.

Kapazitive Sensorsysteme werden unter anderem bei "Passive Entry"-Systemen verwendet, bei denen der Benutzer nicht mehr aktiv eine Taste einer Funkfernbedienung zum Öffnen eines Fahrzeuges zu betätigen braucht. Vielmehr reicht es aus, dass der Benutzer eine auch als ID-Geber (Identifikationsgeber) bezeichnete Funkfernbedienung mit sich führt. Sobald sich ein Benutzer einer Annäherungserfassungsvorrichtung nähert, wird dies von dem kapazitiven Annäherungssensor erfasst, woraufhin ein in dem Kraftfahrzeug angeordnetes Steuergerät über eine Sendeantenne ein Funksignal an den ID-Geber sendet, welches den ID-Geber aus dem sogenannten "Sleep-Mode" weckt. Der Empfang des Aufwecksignals initiiert einen Funkdialog zwischen dem ID-Geber und dem Steuergerät des Kraftfahrzeuges, bei welchem die Berechtigung bzw. Nicht-Berechtigung des ID-Gebers zum Öffnen des Kraftfahrzeuges ermittelt wird. Sofern im Laufe des Funkdialoges die Berechtigung des ID-Gebers ermittelt wird, wird ein dem Sensorsystem zugeordnetes Schloss des Kraftfahrzeuges entriegelt, so dass durch eine anschließende Betätigung einer Handhabe oder die Ausführung bestimmter Gesten ein Schloss (Türschloss, Kofferraum, Motorhaube) geöffnet werden kann.

Die üblicherweise verwendeten kapazitiven Annäherungssensoren sind stark von Umgebungsbedingungen abhängig; Luftfeuchtigkeit, Niederschläge und sonstige Einflüsse können die Kapazität des Sensorsystems beeinflussen, so dass die Detektion der Annäherung eines Körperteils des Bedieners aufgrund der Störeinflüsse erschwert ist.

Aus dem Stand der Technik sind beispielsweise Türgriffsysteme, bei welchen kapazitive Annäherungssensoren Verwendung finden, beschrieben, die gegenüber Umwelteinflüssen geschützt sind. Beispielsweise offenbart die EP 03 100 728.9 ein System, bei welchem die kapazitive Sensoranordnung hinter einer Gehäusewandung angeordnet ist. Der Raum zwischen der Sensoranordnung und der Gehäusewandung ist mit einem elektrisch isolierenden Material gefüllt, um das Eintreten von Feuchtigkeit oder anderweitigen Fremdstoffen, die die Kapazität des Sensorsystems beeinflussen könnten, zu verhindern.

Eine weitere kapazitive Sensoranordnung ist in der US 2008/0290668 beschrieben.

Insbesondere in der Nähe der Elektroden des kapazitiven Sensors ist der Einfluss störender Effekte möglichst zu vermeiden. Dazu wird im Stand der Technik beispielsweise vorgeschlagen, kapazitive Sensoren in einer Vergussmasse einzubetten, um so eine unmittelbare Beeinflussung der Sensorflächen zu verhindern. Gemäß diesem Stand der Technik wird der gesamte Raum zwischen solch einer vergossenen Elektrodenanordnung und einer Wandung eines Türgriffs mit isolierendem Material verfüllt.

Nachteilig bei diesem System ist jedoch, dass der Einfluss des Materials, auch wenn er schädliche Einflüsse von dem Detektionsbereich des kapazitiven Sensors abhält, der Detektionsempfindlichkeit des kapazitiven Sensors abträglich ist. Zwar ist das Material elektrisch isolierend, die Kapazität wird von diesem Dielektrikum dennoch beeinflusst.

Nachteilig bei den Lösungen gemäß dem Stand der Technik ist es ferner, dass die verwendeten Bauteile spezielle für eine Sensorvorrichtung hergestellt werden müssen, das heißt nicht bei ähnlichen Systemen verwendet werden können. Es sind demnach für jede Anwendung spezielle Bauteile zu fertigen, was die Kosten für die bekannten Vorrichtungen erhöht.

Aufgabe der Erfindung ist es, eine universell einsetzbare, gegen Umwelteinflüsse geschützte Annäherungserfassungsvorrichtung mit hoher Detektionsempfindlichkeit bereitzustellen.

Die Aufgabe wird erfindungsgemäß durch eine Annäherungserfassungsvorrichtung gemäß Anspruch 1 gelöst.

Die erfindungsgemäße Annäherungserfassungsvorrichtung umfasst einen eine Ausnehmung aufweisenden Sensorträger, wobei in der Ausnehmung des Sensorträgers eine Sensorelektronik angeordnet ist, die zumindest einen mit einer Auswerteschaltung gekoppelten kapazitiven Annäherungssensor mit einer aktiven kapazitiven Fläche zur Erfassung von Annäherungen aufweist.

Die Annäherungserfassungsvorrichtung umfasst ferner einen Trägerrahmen mit einer Detektionsöffnung. Der Sensorträger ist derart an dem Trägerrahmen befestigt, dass die aktive kapazitive Fläche des kapazitiven Annäherungssensors zur Detektionsöffnung ausgerichtet und von dieser freigegeben ist, das heißt die aktive kapazitive Fläche nicht durch den Trägerrahmen verdeckt ist, um so eine Beeinflussung der Kapazität zu vermeiden. Von der Detektionsöffnung und dem Sensorträger ist ein Aufnahmeraum definiert, wobei der Sensorträger in dem von dem Aufnahmeraum freigegebenen Bereich zumindest eine Erhebung aufweist, die sich vorzugsweise bis zu der Detektionsöffnung in dem Trägerrahmen erhebt. In diesem Fall bildet die zumindest eine Erhebung mit dem Detektionsöffnung bzw. dem Trägerrahmen eine Ebene.

Die erfindungsgemäße Annäherungserfassungsvorrichtung umfasst ferner ein Dichtmittel, welches in den Aufnahmeraum eingegossen oder eingeschäumt ist und zumindest eine zu einer Erhebung komplementäre Durchgangsöffnung aufweist.

Die erfindungsgemäße Annäherungsvorrichtung ist weitgehend modular aufgebaut, so dass einzelne Elemente der Annäherungsvorrichtung für verschiedene Anwendungsbereiche angepasst werden können. Bei unterschiedlichen Detektionsszenarien kann beispielsweise einfach eine andere Sensorelektronik in dem Sensorträger verbaut werden. Der Sensorträger und der Trägerrahmen sind vorzugsweise so aufeinander abgestimmt, dass keine aufwendige Befestigung aneinander notwendig ist. Beispielsweise kann der Sensorträger einfach in den Trägerrahmen eingeklipst bzw. eingerastet werden.

Das Dichtmittel ist in den Aufnahmeraum eingegossen oder eingespritzt und härtet in dem Aufnahmeraum aus. Dies hat den Vorteil, dass die Sensorelektronik durch das Verfüllen des Aufnahmeraumes mit dem das Dichtmittel bildenden Kunststoff gegenüber Witterungseinflüssen besonders gut geschützt ist, da sich das Dichtmittel beim Eingießen oder Einschäumen an die Wandung der Detektionsöffnung, die Wandung der zumindest einen Erhebung sowie die Sensorelektronik anlegt und diese abdichtet. Die Schutzeigenschaften eines eingegossen oder eingeschäumten Dichtmittels übertreffen die eines lediglich eingelegten oder eingeklebten Dichtmittels bei weitem, da bei lediglich einer Verklebung nicht ausgeschlossen werden kann, dass kleinste Zwischenräume das Eindringen von beispielsweise Wasser ermöglichen und ggf. sogar fördern (Kapillareffekt).

Die zumindest eine Erhebung des Sensorträgers und die entsprechende Durchgangsöffnung in dem Dichtmittel sorgen für eine erhöhte Detektionsempfindlichkeit der Annäherungserfassungsvorrichtung, da in dem Bereich dieser Erhebungen / Durchgangsöffnungen keine Störung des Detektionsvermögens des kapazitiven Sensors durch das Dichtmittel auftritt. Die Anzahl der Durchgangsöffnungen hängt von dem jeweiligen Anwendungsfall ab.

Durch den weitgehend modularen Aufbau und die Verwendung des eingegossenen oder eingeschäumten Dichtmittels mit Durchgangsöffnungen in Kombination mit den Erhebungen des Sensorträgers wird eine Annäherungserfassungsvorrichtung bereitgestellt, die kostengünstig hergestellt und universell eingesetzt werden kann und dabei gleichzeitig gegen Witterungseinflüsse geschützt ist und eine hohe Detektionsempfindlichkeit aufweist.

Die erfindungsgemäße Annäherungserfassungsvorrichtung wird durch beliebige, dem Fachmann bekannte Befestigungsmethoden an einem Karosserieteil eines Kraftfahrzeuges befestigt, wobei durch das Dichtmittel ein Schutz der Sensorelektronik gewährleistet ist.

Um diese Schutzfunktion zu erhöhen, ist es bei einer bevorzugten Ausführungsform vorgesehen, dass das Dichtmittel aus einem Elastomer gebildet und derart in den Aufnahmeraum eingegossen oder eingeschäumt ist, dass es über die Detektionsöffnung in dem Trägerrahmen hervorsteht. Bei der Befestigung der Annäherungserfassungsvorrichtung wird das Dichtmittel zwischen dem Sensorträger bzw. dem Trägerrahmen und dem Karosserieteil komprimiert, so dass ein Eindringen von beispielsweise Feuchtigkeit weiter erschwert wird, da sich das Dichtmittel bei dem Komprimierung über die Detektionsöffnung nach außen (auf den Trägerrahmen) ausdehnt und so weiter abdichtet.

Bei dem das Dichtmittel bildenden Elastomer kann es sich beispielsweise um einen Kunststoff auf Polyurethanbasis handeln, und die Verwendung eines Dichtmittels mit elastomeren Eigenschaften gewährleistet eine Komprimierbarkeit bei der Befestigung der Annäherungserfassungsvorrichtung an dem Karosserieteil. Das Dichtmittel ist vorzugsweise blasen- und porenfrei, um ein Einkriechen von Feuchtigkeit zu vermeiden.

Das Eingießen bzw. Einschäumen des Dichtmittels in den Aufnahmeraum muss stets so geschehen, dass das Dichtmittel die Erhebungen nicht abdeckt, d.h. zu der mindestens einen Erhebung eine komplementäre Durchgangsöffnung in dem Dichtmittel verbleibt, da diese für die hohe Detektionsempfindlichkeit der erfindungsgemäßen Annäherungserfassungsvorrichtung wesentlich ist.

Das Dichtmittel kann entsprechend ausgebildet werden, indem genau abgestimmte Mengen des das Dichtmittel ausbildenden Kunststoffs in den Aufnahmeraum gegossen bzw. eingeschäumt werden und das Eingießen bzw. Einschäumen auf die zumindest eine Erhebung abgestimmt ist.

Um das Ausgestalten des Dichtmittels zu erleichtern, ist es bei einer bevorzugten Ausführungsform vorgesehen, dass der Trägerrahmen und die zumindest eine Erhebung jeweils einen von einer durch den Trägerrahmen gebildeten Ebene vorspringenden Kragen aufweisen. Ein entsprechender Kragen verhindert, dass beim Eingießen des das Dichtmittel bildenden Kunststoffs dieser die Erhebung überdeckt oder sich über den Trägerrahmen hinaus ausdehnt. Die Kragen können beispielsweise aus einem ebenfalls elastomeren Material bestehen, welches beim Befestigen des Annäherungserfassungsvorrichtung, ggf. zusammen mit dem Dichtmittel, komprimiert wird. Alternativ können die Kragen aus einem dünnen, spröden Material bestehen, welches beim Befestigen wegbricht.

Die Kragen selber können mit der zumindest einen Erhebung und dem Trägerrahmen einstückig ausgebildet sein. Alternativ kann es sich um separate Bauteile handeln, die an der zumindest einen Erhebung und dem Trägerrahmen befestigt sind.

Wie bereits angemerkt, wird die Annäherungserfassungsvorrichtung an einem Karosserieteil eines Kraftfahrzeuges befestigt, wozu beliebige Methoden / Bauteile zum Einsatz kommen können. Zur Vereinfachung der Befestigung der Annäherungserfassungsvorrichtung an dem Karosserieteil ist es bei einer bevorzugten Ausführungsform der Erfindung vorgesehen, dass das Dichtmittel als Dicht- und Klebmittel ausgebildet ist, mit welchem die Annäherungserfassungsvorrichtung an einem Karosserieteil des Kraftfahrzeuges befestigbar ist. Eine entsprechende Ausführungsform lässt sich besonders einfach und ohne zusätzliche Bauteile befestigen. Die Elastizität des Dicht- und Klebemittels gewährleistet, dass die Annäherungserfassungsvorrichtung auch an einem unebenen Untergrund (Karosserieteil) problemlos befestigt werden kann.

Alternativ kann auf der dem Karosserieteil des Kraftfahrzeuges zugewandten Fläche des Dichtmittels zumindest abschnittsweise eine Klebebeschichtung angeordnet sein, mit welcher die Annäherungserfassungsvorrichtung an dem Karosserieteil des Kraftfahrzeuges befestigbar ist.

Bei einer Ausführungsform der erfindungsgemäßen Annäherungserfassungsvorrichtung umfasst der Trägerrahmen einen Befestigungsabschnitt, mit welchem die Annäherungserfassungsvorrichtung an einem Karosserieteil des Kraftfahrzeuges befestigbar ist. Die Befestigung über den Befestigungsabschnitt kann alternativ oder zusätzlich zu den vorgenannten Befestigungsmethoden verwendet werden. Auch eine Befestigung über ein entsprechendes Bauteil der Annäherungserfassungsvorrichtung hat den Vorteil, dass keine speziellen Befestigungsmittel an dem Karosserieteil vorhanden sein müssen, so dass die Annäherungserfassungsvorrichtung bei entsprechender Ausgestaltung des Befestigungsabschnitts an beliebige Karosserieteile angepasst werden kann.

Die Annäherungserfassungsvorrichtung kann über den Befestigungsabschnitt und / oder das Dicht- bzw. Dicht- und Klebmittel an einem Karosserieteil des Kraftfahrzeuges befestigt werden. Findet eine Befestigung mit Hilfe des Befestigungsabschnitts (alleine oder in Kombination mit dem Dicht- bzw. Dicht- und Klebmittel) statt, kann die Annäherungserfassungsvorrichtung über in dem Befestigungsabschnitt vorhandenen Öffnungen mit entsprechenden Befestigungsmitteln an der Karosserie des Kraftfahrzeuges verschraubt werden. Eine entsprechende Befestigung ist jedoch insofern nachteilig, als das ein Eingriff in das Karosseriebauteil stattfindet und zusätzliche Befestigungsmittel notwendig sind.

Eine bevorzugte Ausführungsform der Annäherungserfassungsvorrichtung ist dadurch gekennzeichnet, dass auf der dem Karosserieteil des Kraftfahrzeuges zugewandten Fläche des Befestigungsabschnitts des Trägerrahmens zumindest abschnittsweise eine Klebebeschichtung angeordnet ist, mit welcher die Annäherungserfassungsvorrichtung an dem Karosserieteil des Kraftfahrzeuges befestigbar ist. Die Notwendigkeit zusätzlicher Befestigungsmittel, die in das Karosserieteil eingreifen, ist nicht mehr gegeben, die Annäherungserfassungsvorrichtung lässt sich rasch und ohne großen Aufwand über die Klebebeschichtung an dem Karosserieteil befestigen.

Die erfindungsgemäße Annäherungserfassungsvorrichtung ist modular aus einfachen Bauteilen aufgebaut, so dass die Kosten gering gehalten werden können. Um zu vermeiden, dass für verschiedene Fahrzeugtypen verschiedene Trägerrahmen vorrätig gehalten werden müssen, die an die Formgebung des Karosserieteiles, an welchem die Annäherungserfassungsvorrichtung befestigt werden soll, angepasst sind, ist bei einer bevorzugten Ausführungsform der Annäherungserfassungsvorrichtung auf dem Befestigungsabschnitt oder dem Trägerrahmen eine die Detektionsöffnung freigebende Adapterschicht angeordnet, über welche die Annäherungserfassungsvorrichtung an dem Karosserieteil des Kraftfahrzeuges befestigbar ist. Die Befestigung kann wiederum durch eine auf der Adapterschicht angeordnete Klebebeschichtung oder andere, dem Fachmann bekannte Befestigungsmittel erfolgen. Die Verwendung der Adapterschicht hat den Vorteil, dass sämtliche verbleibenden Bauteile der Annäherungserfassungsvorrichtung unabhängig von der speziellen Formgebung des Karosserieteiles, an welchem die Annäherungserfassungsvorrichtung befestigt werden soll, sind. Bei verschieden geformten Karosserieteilen ist somit lediglich eine Anpassung der Adapterschicht notwendig; sämtliche andere Bauteile sind unabhängig von der Formgebung des Karosserieteiles.

Bei einem bevorzugten Ausführungsbeispiel der Annäherungserfassungsvorrichtung weist der Sensorträger einen Stützabschnitt und die Sensorelektronik einen Steckverbinder auf, wobei der Steckverbinder lösbar in dem Stützabschnitt befestigt ist. Über den Steckverbinder wird die Sensorelektronik in dem Sensorträger mit der Fahrzeugelektronik verbunden, wobei der Steckverbinder vorzugsweise als Schnellverschluss ausgebildet ist, so dass ein rascher Anschluss an die Fahrzeugelektronik möglich ist. Der Steckverbinder fasst sämtliche elektrischen Leitungen der Sensorelektronik zusammen, so dass bei Vorhandensein eines entsprechenden Steckverbinders auf Seiten des Kraftfahrzeuges eine schnelle, gegen Witterungseinflüsse geschützte und sichere Verbindung hergestellt werden kann.

Im Nachfolgenden wird die erfindungsgemäße Annäherungserfassungsvorrichtung anhand der Zeichnung detaillierter beschrieben, in welcher
Figuren 1A-1C verschiedene Ansichten einer ersten Ausführungsform der Annäherungserfassungsvorrichtung zeigen,
Figur 2 eine Seitenansicht der ersten Ausführungsform gemäß den Figuren 1A-1C mit entferntem Dichtmittel zeigt,
Figur 3 eine Seitenansicht einer zweiten Ausführungsform der erfindungsgemäßen Annäherungserfassungsvorrichtung zeigt,
Figur 4 eine Explosionsdarstellung einer dritten Ausführungsform zeigt, und
Figur 5 eine detailliertere Explosionsdarstellung einer vierten Ausführungsform zeigt.

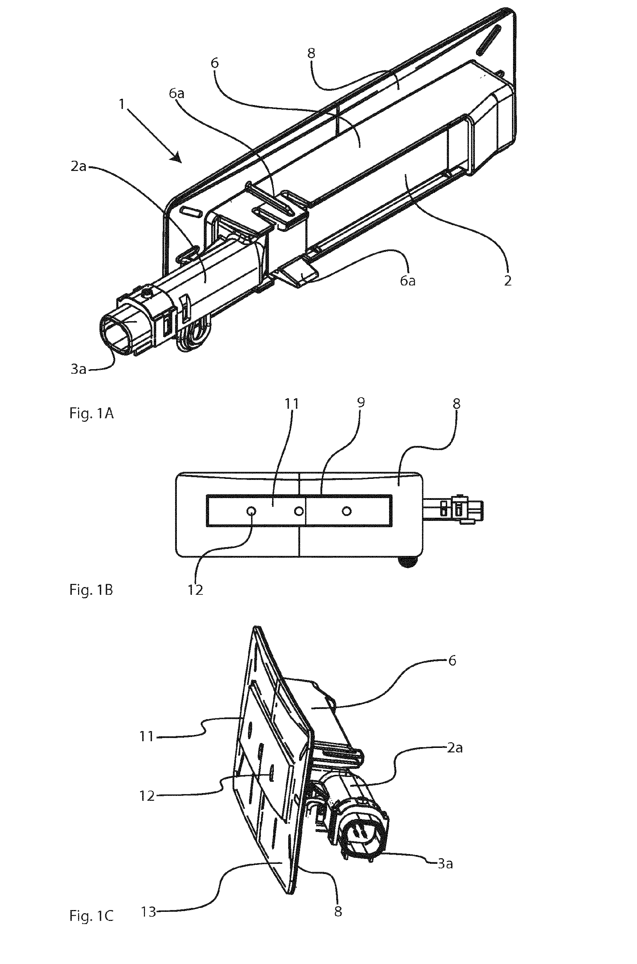

Die Figuren 1A-1C zeigen verschiedene Ansichten einer ersten Ausführungsform der erfindungsgemäßen Annäherungserfassungsvorrichtung 1. Die Annäherungserfassungsvorrichtung umfasst einen Trägerrahmen 6, der einen Befestigungsabschnitt 8 (siehe Fig. 1B) und eine Detektionsöffnung 9 aufweist. Über den Befestigungsabschnitt 8 kann die Annäherungserfassungsvorrichtung 1 an einem Karosserieteil eines Kraftfahrzeuges befestigt werden. Dazu kann auf der dem Karosserieteil des Kraftfahrzeuges zugewandten Fläche des Befestigungsabschnittes 8 des Trägerrahmens 6 zumindest abschnittsweise eine Klebebeschichtung 13 angeordnet sein, über welche die Annäherungserfassungsvorrichtung 1 an dem Karosserieteil befestigbar ist. Alternativ kann die Annäherungserfassungsvorrichtung 1 über beispielsweise Schrauben mit dem Karosserieteil befestigt sein.

In dem Trägerrahmen 6 ist ein Sensorträger 2 angeordnet. Bei der gezeigten Ausführungsform umfasst der Trägerrahmen zwei Haltemittel 6a sowie eine Aufnahmeöffnung, über welche der Sensorträger 2 in dem Trägerrahmen 6 festgelegt ist.

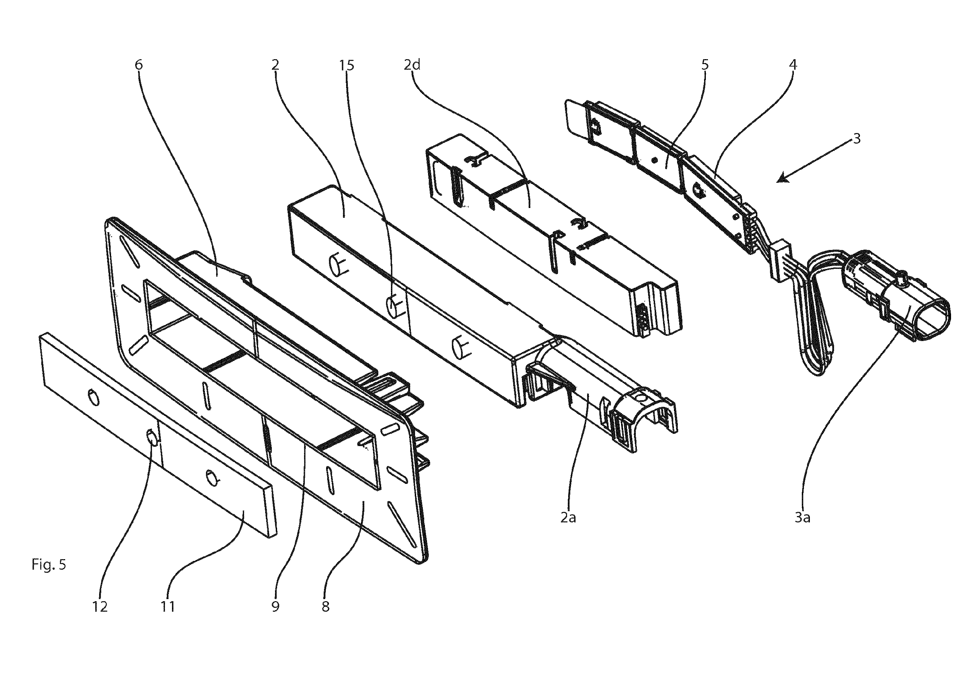

In einer Ausnehmung des Sensorträgers wiederum ist eine (in den Figuren 1A-1C nicht erkennbare) Sensorelektronik 3 angeordnet, die zumindest einen mit einer Auswerteschaltung gekoppelten kapazitiven Annäherungssensor 4 mit einer aktiven kapazitiven Fläche 5 zur Erfassung von Annäherungen aufweist. Die Sensorelektronik 3 bzw. deren Anordnung in dem Sensorträger 2 ist mit der in Figur 5 gezeigten vergleichbar, wobei bei der in Figur 5 gezeigten Ausführungsform ein weiteres Bauelement verwendet wird, welches bei der ersten Ausführungsform nicht vorgesehen ist.

Die Sensorelektronik ist derart in dem Sensorträger 2 angeordnet, dass die aktive kapazitive Fläche 5 des kapazitiven Annäherungssensors 4 in Richtung auf die Detektionsöffnung 9 in dem Trägerrahmen 6 ausgerichtet ist, das heißt die Detektionsöffnung 9 die aktive kapazitive Fläche 5 des kapazitiven Annäherungssensors 4 freigibt, um eine Beeinflussung der Detektion zu vermeiden.

Der Sensorträger 2 wiederrum ist derart in dem Trägerrahmen 6 angeordnet, dass die der Detektionsöffnung 9 zugewandte Fläche des Sensorträgers nicht mit der durch den Befestigungsabschnitt 8 des Trägerrahmens 6 gebildeten Ebene abschließt, sondern vielmehr von dieser Ebene nach innen verlagert ist, so dass die Detektionsöffnung 9 und der Sensorträger 2 einen Aufnahmeraum 10 bilden, in welchem ein Dichtmittel 11 angeordnet ist.

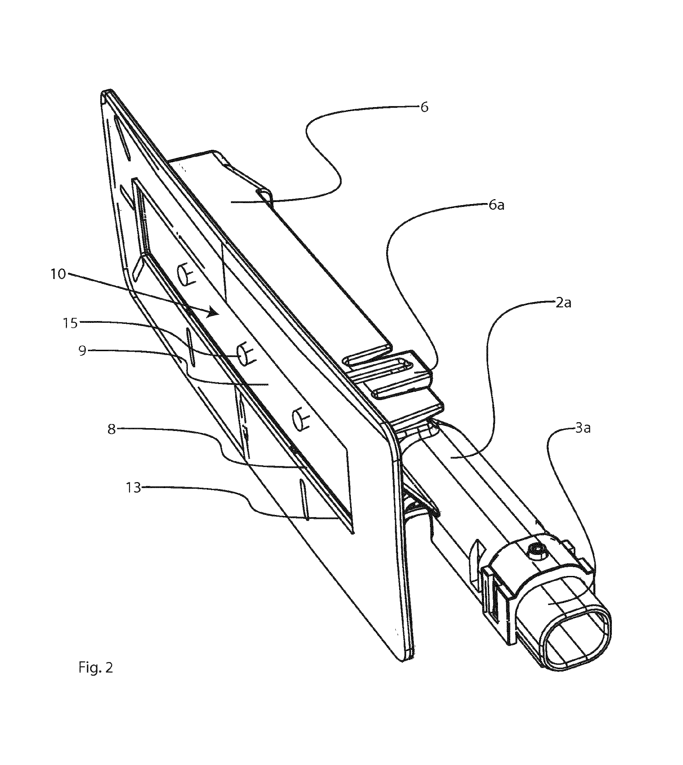

Der Aufnahmeraum 10 ist insbesondere bei der in Figur 2 dargestellten seitlichen Ansicht der in den Figuren 1A-1C gezeigten Ausführungsform zu erkennen. Bei Figur 2 ist die Klebebeschichtung 13 auf dem Befestigungsabschnitt 8 des Trägerrahmens 6 besonders deutlich zu erkennen.

Das Dichtmittel 11 besteht bei der gezeigten Ausführungsform aus einem elastomeren Kunststoff, beispielsweise auf Polyurethanbasis (z.B. Sikaflex®), und ist in den Aufnahmeraum 10 gespritzt oder gegossen, wodurch ein besonders guter Schutz der Sensorelektronik gewährleistet ist.

Das Dichtmittel 11 umfasst drei Durchgangsöffnungen 12, die in Kombination mit drei Erhebungen 15 (siehe Figur 2) des Sensorträgers, die in den Aufnahmeraum 10 ragen, für eine hohe Detektionsempfindlichkeit sorgen. Bei dem Vergießen oder Einschäumen des das Dichtmittel bildenden Kunststoffs ist dabei darauf zu achten, dass im Bereich der Erhebungen 15 Durchgangsöffnungen 12 in dem Dichtmittel 11 entstehen bzw. erhalten werden.

Wie insbesondere in Figur 1C zu sehen ist, ragt das Dichtmittel 11 in der nicht-befestigten Form der Annäherungserfassungsvorrichtung 1 bei der ersten Ausführungsform über die von dem Befestigungsabschnitt 8 des Trägerrahmens 6 gebildeten Ebene hinaus, so dass bei Befestigung an dem Karosserieteil eine Komprimierung des Dichtmittels stattfindet. Bei einer derartigen Ausführung der Annäherungserfassungsvorrichtung muss ein Dichtmittel aus einem elastomeren Kunststoff verwendet werden, so dass bei der Befestigung eine Komprimierung des Dichtmittels möglich ist.

Auf der der Detektionsöffnung 9 zugewandten Oberfläche des Sensorträgers 2 sind bei der ersten Ausführungsform drei Erhebungen 15 vorgesehen, die zu den Durchgangsöffnungen 12 in dem Dichtmittel 11 komplementär sind. Neben der Erhöhung der Detektionsempfindlichkeit fixieren die Erhebungen das Dichtmittel in dem Aufnahmeraum und gewährleisten ferner, dass keine zu starke Komprimierung des Dichtmittels 11 bei der Anbringung der Annäherungserfassungsvorrichtung stattfindet.

Der Sensorträger 2 umfasst einen Stützabschnitt 2a, in welchem ein Steckverbinder 3a als Teil der Sensorelektronik 3 gehalten ist. Über diesen Steckverbinder 3a wird die Sensorelektronik 3 der Annäherungserfassungsvorrichtung mit der Fahrzeugelektronik verbunden. Die Sensorelektronik 3 kann die mit dem kapazitiven Annäherungssensor 4 gekoppelte Auswerteschaltung enthalten, diese kann jedoch auch Teil der Fahrzeugelektronik sein. Mit Hilfe des Steckverbinders 3a lässt sich die Sensorelektronik schnell und sicher mit der vorgenannten Fahrzeugelektronik verbinden.

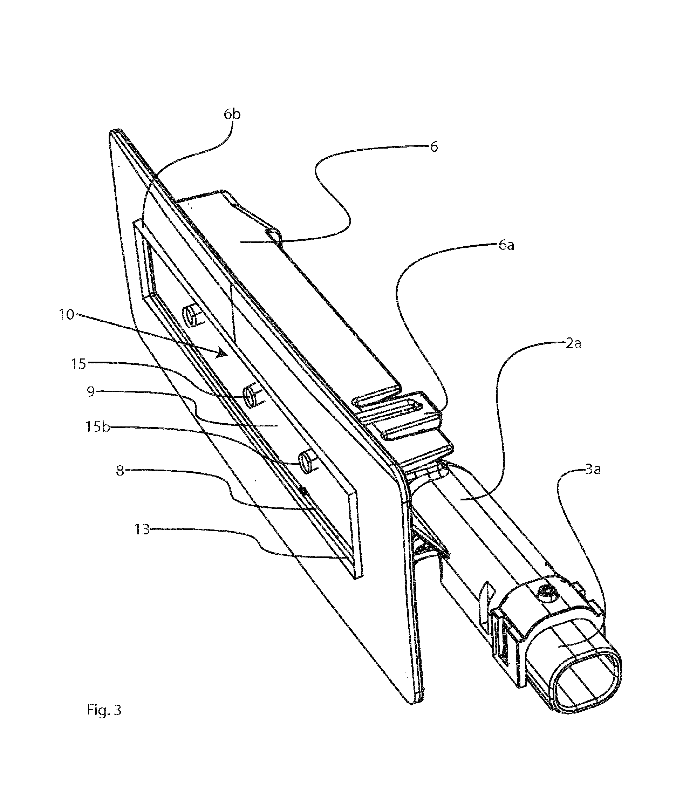

Die Figur 3 zeigt eine Explosionsdarstellung einer zweiten Ausführungsform der erfindungsgemäßen Annäherungserfassungsvorrichtung, wobei die gezeigte Ausführungsform der ersten Ausführungsform weitgehend entspricht und lediglich geringfügige Unterschiede vorliegen, auf die nachfolgend eingegangen wird.

Die Annäherungserfassungsvorrichtung gemäß der zweiten Ausführungsform umfasst einen Kragen 6b an dem Trägerrahmen und je einen Kragen 15b an den Erhebungen, wobei die Kragen über die von Trägerrahmen (bzw. der Detektionsöffnung) und ggf. den Erhebungen (falls diese entsprechend weit aus dem Aufnahmeraum 10 ragen) aufgespannten Ebene hinausragen.

Die Kragen 6b, 15b erweitern den Aufnahmeraum und gewährleisten beim Vergießen bzw. Einschäumen des das (in dieser Figur nicht gezeigten) Dichtmittel bildenden Kunststoffs, dass in dem Dichtmittel bei den Erhebungen 15 Durchgangsöffnungen 12 ausgebildet sind, die für eine hohe Detektionsempfindlichkeit wesentlich sind. Ferner wird ein "Überlaufen" des Kunststoffes auf den Trägerrahmen verhindert.

Die Kragen bestehen aus einem Material, welches bei der Befestigung der Annäherungserfassungsvorrichtung an dem Karosserieteil nicht hinderlich ist, weil es beispielsweise elastisch ist (Kragen aus z.B. Gummi oder einer Gummimischung) oder ohne großen Kraftaufwand wegbricht.

Bei der gezeigten Ausführungsform ist der Kragen 6b des Trägerrahmens 6 bei der Detektionsöffnung 9 angeordnet, so dass ein "Überlaufen" auf den Rest des Trägerrahmens (z.B. den Befestigungsabschnitt) verhindert wird. Bei einer (nicht gezeigten) alternativen Ausführungsform kann der Kragen des Trägerahmens auch außen (beispielsweise außen an dem Befestigungsabschnitt 8, der Teil des Trägerrahmens ist) angeordnet sein, so dass bei dem Eingießen bzw. Einschäumen des das Dichtmittel bildenden Kunststoffs sich dieser über Bereiche des Trägerrahmens ausdehnt, so dass sich das Dichtmittel auch über Bereichen des Trägerrahmens erstreckt, wodurch die Fläche des Dichtmittels vergrößert ist. Eine entsprechende Ausführung ist insbesondere dann vorteilhaft, wenn die Annäherungserfassungsvorrichtung über das Dichtmittel an dem Karosserieteil befestigt werden soll, indem das Dichtmittel beispielsweise eine Klebebeschichtung aufweist oder das Dichtmittel als Dicht- und Klebemittel ausgebildet ist, d.h. Dicht- und Klebefunktionen innehat.

Eine Dicht- und Klebefunktion des Dichtmittels kann beispielsweise erreicht werden, wenn die Annäherungserfassungsvorrichtung vor einem Aushärten des das Dichtmittel bildenden Kunststoffs mittels dieses Dicht- und Klebemittels an dem Karosserieteil befestigt wird (wobei weitere Befestigungsmittel unterstützend wirken können).

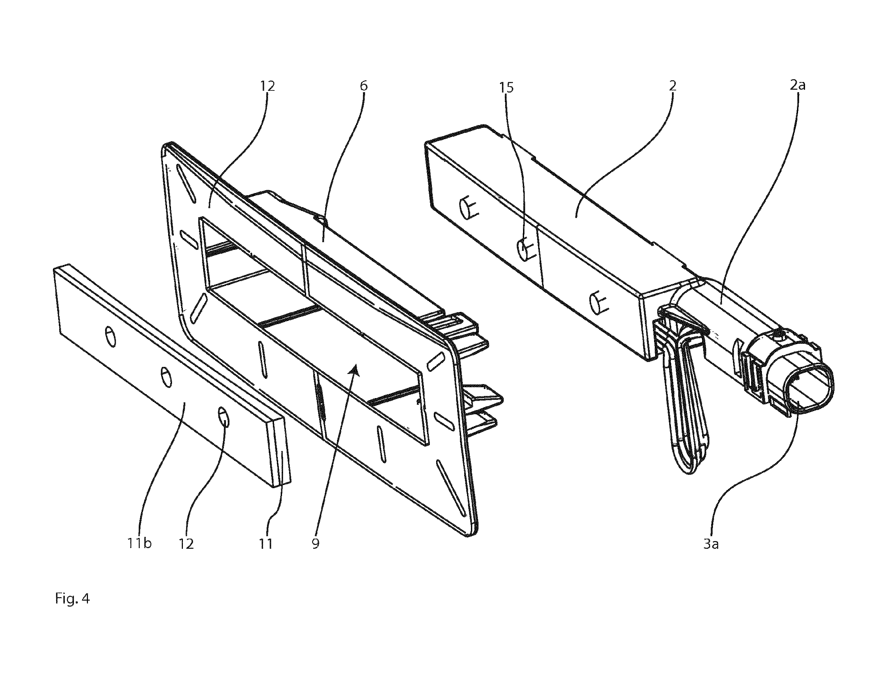

Die Figur 4 zeigt eine Explosionsdarstellung einer dritten Ausführungsform der erfindungsgemäßen Annäherungserfassungsvorrichtung, wobei die gezeigte Ausführungsform der ersten Ausführungsform weitgehend entspricht und lediglich geringfügige Unterschiede vorliegen, auf die nachfolgend eingegangen wird.

Bei der gezeigten Ausführungsform umfasst das Dichtmittel 11 eine Klebebeschichtung 11b, über welche, ggf. unter Mitwirkung weiterer Befestigungsmittel, die Annäherungserfassungsvorrichtung an dem Karosserieteil befestigt werden kann.

Figur 5 zeigt eine detaillierte Explosionsdarstellung einer vierten Ausführungsform der erfindungsgemäßen Annäherungserfassungsvorrichtung. Bei dieser Darstellung sind Details der Sensorelektronik zu erkennen; eine entsprechend aufgebaute (nicht unbedingt identische) Sensorelektronik 3 ist auch Teil der ersten Ausführungsform, wobei die Sensorelektronik bei den Figuren 1A - 1C, sowie 2, 3 und 4 nicht dargestellt ist.

Die Sensorelektronik 3 umfasst einen kapazitiven Annäherungssensor 4, der in dem vorliegenden Fall drei Elektroden umfasst, die eine aktive kapazitive Fläche 5 bilden. Die Anzahl der Elektroden und deren genaue räumliche Anordnung in dem Sensorträger ist abhängig von dem jeweiligen Anwendungsfall und nicht auf die dargestellt spezielle Anordnung beschränkt.

Bei der in dieser Figur gezeigten Ausführungsform umfasst der Sensorträger ein Stützelement 2d, in welchem die Sensorelektronik 3 fixiert ist, so dass eine Bewegung der Sensorelektronik in dem Sensorträger verhindert ist. Das Stützelement 2d ist speziell auf die Form der Sensorelektronik 3 abgestimmt. Sobald die Sensorelektronik 3 in dem Stützelement 2d befestigt ist, wird dieses einfach in den Sensorträger 2 eingeschoben, welcher dann wiederum in bzw. an dem Trägerrahmen 6 festgelegt wird. Der Sensorträger 2 und der Trägerrahmen 6 sind bei der gezeigten Ausführungsform unabhängig von der Gestaltung der Sensorelektronik 3, da diese über das Stützelement in dem Sensorträger festgelegt wird.

Die Sensorelektronik 3 variiert je nach Anwendungsgebiet und Ausgestaltung des Karosserieteils, an welchem die Annäherungserfassungsvorrichtung zu befestigen ist. Je nach Ausgestaltung der Sensorelektronik 3, und insbesondere des kapazitiven Annäherungssensors 4 der Sensorelektronik 3, ist das Dichtmittel 11 gestaltet.

## Patentansprüche

1. Annäherungserfassungsvorrichtung (1) für Kraftfahrzeuge, mit
einem eine Ausnehmung aufweisenden Sensorträger (2),
einer in der Ausnehmung des Sensorträgers (2) angeordneten Sensorelektronik (3), die zumindest einen mit einer Auswerteschaltung gekoppelten kapazitiven Annäherungssensor (4) mit einer aktiven kapazitiven Fläche (5) zur Erfassung von Annäherungen aufweist, und
einem Trägerrahmen (6) mit einer Detektionsöffnung (9), wobei der Sensorträger (2) derart an dem Trägerrahmen (6) befestigt ist, dass die aktive kapazitive Fläche (5) des kapazitiven Annäherungssensors (4) zur Detektionsöffnung ausgerichtet und von dieser freigegeben ist und dass von der Detektionsöffnung (9) und dem Sensorträger (2) ein Aufnahmeraum (10) gebildet ist, und wobei der Sensorträger (2) in dem von dem Aufnahmeraum (10) freigegebenen Bereich zumindest eine Erhebung (15) aufweist,
und mit einem Dichtmittel (11), welches in den Aufnahmeraum (10) eingegossen oder eingeschäumt ist und zumindest eine zu einer Erhebung (15) komplementäre Durchgangsöffnung (12) aufweist.

2. Annäherungserfassungsvorrichtung (1) für Kraftfahrzeuge nach Anspruch 1, **dadurch gekennzeichnet, dass** das Dichtmittel (11) aus einem Elastomer gebildet ist derart in den Aufnahmeraum (10) eingegossen oder eingeschäumt ist, dass es über die Detektionsöffnung (9) in dem Trägerrahmen (6) hervorsteht.

3. Annäherungserfassungsvorrichtung (1) für Kraftfahrzeuge nach Anspruch 2, **dadurch gekennzeichnet, dass** der Trägerrahmen (6) und die zumindest eine Erhebung (15) jeweils einen von einer durch den Trägerrahmen (6) gebildeten Ebene vorspringenden Kragen (6b, 15b) aufweisen.

4. Annäherungserfassungsvorrichtung (1) für Kraftfahrzeuge nach Anspruch 2 oder 3, **dadurch gekennzeichnet, dass** das Dichtmittel (11) als Dicht- und Klebmittel ausgebildet ist, mit welchem die Annäherungserfassungsvorrichtung (1) an einem Karosserieteil des Kraftfahrzeuges befestigbar ist.

5. Annäherungserfassungsvorrichtung (1) für Kraftfahrzeuge nach Anspruch 2 oder 3, **dadurch gekennzeichnet, dass** auf der dem Karosserieteil des Kraftfahrzeuges zugewandten Fläche des Dichtmittels (11) zumindest abschnittsweise eine Klebebeschichtung (11b) angeordnet ist, mit welcher die Annäherungserfassungsvorrichtung (1) an dem Karosserieteil des Kraftfahrzeuges befestigbar ist.

6. Annäherungserfassungsvorrichtung (1) für Kraftfahrzeuge nach einem der Ansprüche 1 bis 5, **dadurch gekennzeichnet, dass** der Trägerrahmen (6) einen Befestigungsabschnitt (8), mit welchem die Annäherungserfassungsvorrichtung (1) an einem Karosserieteil des Kraftfahrzeuges befestigbar ist, umfasst.

7. Annäherungserfassungsvorrichtung (1) für Kraftfahrzeuge nach Anspruch 6, **dadurch gekennzeichnet, dass** auf der dem Karosserieteil des Kraftfahrzeuges zugewandten Fläche des Befestigungsabschnitts (8) des Trägerrahmens (6) zumindest abschnittsweise eine Klebebeschichtung (13) angeordnet ist, mit welcher die Annäherungserfassungsvorrichtung (1) an dem Karosserieteil des Kraftfahrzeuges befestigbar ist

8. Annäherungserfassungsvorrichtung (1) nach einem der Ansprüche 1 - 6, **dadurch gekennzeichnet, dass** auf dem Befestigungsabschnitt (8) oder dem Trägerrahmen (6) eine die Detektionsöffnung freigebende Adapterschicht angeordnet ist, mit welcher die Annäherungserfassungsvorrichtung (1) an dem Karosserieteil des Kraftfahrzeuges befestigbar ist.

9. Annäherungserfassungsvorrichtung (1) nach einem der Ansprüche 1 - 8, **dadurch gekennzeichnet, dass** der Trägerrahmen mehrere Haltemittel (6a) umfasst, mit welchen der Sensorträger (2) in bzw. an dem Trägerrahmen fixiert ist.

10. Annäherungserfassungsvorrichtung (1) nach einem der Ansprüche 1 - 9, **dadurch gekennzeichnet, dass** der Sensorträger (2) einen Stützabschnitt (2a) und die Sensorelektronik (3) einen Steckverbinder (3a) aufweist, wobei der Steckverbinder (3a) lösbar in dem Stützabschnitt (2a) befestigt ist.

## Claims

1. A proximity detection device (1) for motor vehicles, having
a sensor carrier (2) having a recess,
a sensor electronic system (3), which is arranged in the recess of the sensor carrier (2) and has at least one capacitive proximity sensor (4), which is coupled to an evaluation circuit and has an active capacitive surface (5) for detecting proximity, and
a carrier frame (6) having a detection opening (9), wherein the sensor carrier (2) is fastened to the carrier frame (6) in such a manner that the active capacitive surface (5) of the capacitive proximity sensor (4) is aligned with the detection opening and is exposed by the latter, and that an accommodation space (10) is formed by the detection opening (9) and the sensor carrier (2), and wherein the sensor carrier (2) has at least one raised portion (15) in the region exposed by the accommodation space (10),
and having a sealing means (11), which is cast or foamed into the accommodation space (10) and has at least one through opening (12) complementary to a raised portion (15).

2. The proximity detection device (1) for motor vehicles according to Claim 1, **characterised in that** the sealing means (11) is formed from an elastomer and is cast or foamed into the accommodation space (10) in such a manner that it projects beyond the detection opening (9) in the carrier frame (6).

3. The proximity detection device (1) for motor vehicles according to Claim 2, **characterised in that** the carrier frame (6) and the at least one raised portion (15) each have a collar (6b, 15b) that projects from a plane formed by the carrier frame (6).

4. The proximity detection device (1) for motor vehicles according to Claim 2 or 3, **characterised in that** the sealing means (11) is formed as a sealing adhesive with which the proximity detection device (1) can be fastened to a body part of the motor vehicle.

5. The proximity detection device (1) for motor vehicles according to Claim 2 or 3, **characterised in that** on the face of the sealing means (11) that faces the body part of the motor vehicle, an adhesive coating (11b) is arranged at least in some sections, with which adhesive coating the proximity detection device (1) can be fastened to the body part of the motor vehicle.

6. The proximity detection device (1) for motor vehicles according to any one of Claims 1 to 5, **characterised in that** the carrier frame (6) comprises a fastening section (8), with which the proximity detection device (1) can be fastened to a body part of the motor vehicle.

7. The proximity detection device (1) for motor vehicles according to Claim 6, **characterised in that** on the face of the fastening section (8) of the carrier frame (6) that faces the body part of the motor vehicle, an adhesive coating (13) is arranged at least in some sections, with which adhesive coating the proximity detection device (1) can be fastened to the body part of the motor vehicle.

8. The proximity detection device (1) according to any one of Claims 1-6, **characterised in that** an adapter layer, which exposes the detection opening, is arranged on the fastening section (8) or carrier frame (6), with which adapter layer the proximity detection device (1) can be fastened to the body part of the motor vehicle.

9. The proximity detection device (1) according to any one of Claims 1-8, **characterised in that** the carrier frame comprises a plurality of retaining means (6a), with which the sensor carrier (2) is fixed in or to the carrier frame.

10. The proximity detection device (1) according to any one of Claims 1-9, **characterised in that** the sensor carrier (2) has a supporting section (2a) and the sensor electronic system (3) has a connector (3a), wherein the connector (3a) is fastened detachably in the supporting section (2a).

## Revendications

1. Dispositif de détection de proximité (1) pour véhicules automobiles, avec
un support de capteur (2) présentant un évidement,
une électronique de capteur (3) disposée dans l'évidement du support de capteur (2), laquelle présente au moins un capteur de proximité capacitif (4), couplé à un circuit d'évaluation, avec une surface capacitive active (5) pour la détection d'approches à proximité, et
un cadre de support (6) avec une ouverture de détection (9), le support de capteur (2) étant fixé au cadre de support (6) de manière à ce que la surface capacitive active (5) du capteur de proximité capacitif (4) est orientée vers l'ouverture de détection et est libérée par celle-ci, et un espace de réception (10) étant formé par l'ouverture de détection (9) et le support de capteur (2), et le support de capteur (2) présentant, dans la zone libérée par l'espace de réception (10), au moins une élévation (15),
et avec un moyen d'étanchéité (11) qui est coulé ou intégré par moussage dans l'espace de réception (10) et présente au moins une ouverture de passage (12) complémentaire à une élévation (15).

2. Dispositif de détection de proximité (1) pour véhicules automobiles selon la revendication 1, **caractérisé en ce que** le moyen d'étanchéité (11) est formé en un élastomère et est coulé ou intégré par moussage dans l'espace de réception (10) de manière à ce qu'il dépasse de l'ouverture de détection (9) dans le cadre de support (6).

3. Dispositif de détection de proximité (1) pour véhicules automobiles selon la revendication 2, **caractérisé en ce que** le cadre de support (6) et cette au moins une élévation (15) présentent respectivement une collerette (6b, 15b) en saillie d'un plan formé par le cadre de support (6).

4. Dispositif de détection de proximité (1) pour véhicules automobiles selon la revendication 2 ou 3, **caractérisé en ce que** le moyen d'étanchéité (11) est réalisé en tant que moyen d'étanchéité ou adhésif avec lequel il est possible de fixer le dispositif de détection de proximité (1) sur une partie de carrosserie du véhicule automobile.

5. Dispositif de détection de proximité (1) pour véhicules automobiles selon la revendication 2 ou 3, **caractérisé en ce que**, sur la surface du moyen d'étanchéité (11) tournée vers la partie de carrosserie du véhicule automobile, un revêtement adhésif (11b) est disposé, au moins par tronçons, avec lequel il est possible de fixer le dispositif de détection de proximité (1) sur la partie de carrosserie du véhicule automobile.

6. Dispositif de détection de proximité (1) pour véhicules automobiles selon l'une des revendications 1 à 5, **caractérisé en ce que** le cadre de support (6) comprend une partie de fixation (8) avec laquelle il est possible de fixer le dispositif de détection de proximité (1) sur une partie de carrosserie du véhicule automobile.

7. Dispositif de détection de proximité (1) pour véhicules automobiles selon la revendication 6, **caractérisé en ce que**, sur la surface de la partie de fixation (8) du cadre de support (6) tournée vers la partie de carrosserie du véhicule automobile, un revêtement adhésif (13) est disposé, au moins par tronçons, avec lequel il est possible de fixer le dispositif de détection de proximité (1) sur la partie de carrosserie du véhicule automobile.

8. Dispositif de détection de proximité (1) selon l'une des revendications 1-6, **caractérisé en ce que**, sur la partie de fixation (8) ou le cadre de support (6) est disposée une couche d'adaptation libérant l'ouverture de détection, avec laquelle il est possible de fixer le dispositif de détection de proximité (1) sur la partie de carrosserie du véhicule automobile.

9. Dispositif de détection de proximité (1) selon l'une des revendications 1-8, **caractérisé en ce que** le cadre de support comprend plusieurs moyens de retenue (6a) avec lesquels le support de capteur (2) est fixé dans ou sur le cadre de support.

10. Dispositif de détection de proximité (1) selon l'une des revendications 1-9, **caractérisé en ce que** le support de capteur (2) présente une partie d'appui (2a) et l'électronique de capteur (3) un connecteur enfichable (3a), le connecteur enfichable (3a) étant fixé de manière détachable dans la partie d'appui (2a).
